# EUROPÄISCHE PATENTANMELDUNG

(11) **EP 0 932 182 A2**
(43) Veröffentlichungstag der Anmeldung: **28.07.1999**
(21) Anmeldenummer: 98122381.1
(22) Anmeldetag: 25.11.1998
(51) Int. Cl.: H01J 37/252

(54) **Verfahren und Vorrichtung zum Testen eines Substrats**

(30) Priorität: 26.01.1998 DE 19802848
(71) Anmelder: ETEC EBT GmbH, 85622 Feldkirchen (DE)
(72) Erfinder: Brunner, Matthias Dr., 85551 Kirchheim (DE); Schmid, Ralf Dr., 85586 Poing (DE)
(74) Vertreter: Tetzner, Volkmar, Dr.-Ing. Dr. jur.

(57) **Zusammenfassung**

Die Erfindung betrifft ein Verfahren und eine Vorrichtung zum Testen eines Substrats, wobei ein Korpuskularstrahl auf das Substrat gerichtet wird und ausgelöste Sekundärkorpuskel mit einem Detektor detektiert und anschließend ausgewertet werden. Erfindungsgemäß wird der Ort der am Substrat ausgelösten Sekundärkorpuskel bezüglich der Position des Detektors beim Testen berücksichtigt.

## Beschreibung

Die Erfindung betrifft ein Verfahren sowie eine Vorrichtung zum Testen eines Substrats, wobei ein Korpuskularstrahl auf das Substrat gerichtet wird und ausgelöste Sekundärkorpuskel mit einem Detektor detektiert und anschließend ausgewertet werden.

Die zu testenden Substrate weisen beispielsweise eine Vielzahl von mikroelektronischen oder mikromechanischen Elementen auf, die oft schon in einem Zwischenstadium der Herstellung überprüft werden müssen. Zu diesen Elementen gehören beispielsweise Dünnschichttransistoren oder andere aktive Elemente einer Flüssigkristall-Display-Matrix auf einer Glasplatte vor dem Zusammenbau mit dem Farbfilter, Verbindungsnetzwerke eines Multichip-Modul-Substrates vor der Bestückung mit ICs, Transistoren eines integrierten Schaltkreises auf einem Wafer vor dem Sägen und Sonden, Elektronenemitter und Verbindungen eines Emitterarrays für ein FED-Display vor dem Zusammenbau mit einer Gegenelektrode und dem Evakuieren, und Sensoren jeglicher Art auf ihrem jeweiligen Trägersubstrat.

Diesen Elementen ist gemeinsam, daß sie in mehreren Prozeßschritten, bestehend aus Maskieren, Ätzen, Abscheiden usw. hergestellt werden. Dabei können Fehler durch Partikel, Fehljustage, defekte Prozeßgeräte und dergleichen entstehen. Diese Fehler können zur Störung der Eigenschaften einzelner Elemente auf dem Substrat führen. Es ist daher wünschenswert, die Funktion jedes einzelnen Elementes vor der Weiterverarbeitung prüfen zu können und das entsprechende Substrat zu verwerfen oder zu reparieren sowie Prozeßmängel zu identifizieren und zu beseitigen.

Das Testen dieser Elemente stellt durch die kleinen Dimensionen besondere Anforderungen an die Vorrichtung und das Verfahren. Die mechanische Kontaktierung zur Messung elektrischer Größen scheitert zunehmend an der Größe der Meßpunkte und erfordert eine sehr hohe Präzision. Zusätzlich kann eine mechanische Berührung, wegen der damit verbundenen Schädigung der Kontaktfläche, in vielen Fällen nicht toleriert werden. Ähnliche Einschränkungen gelten auch für die Messung anderer, z.B. mechanischer Größen, durch mechanisch einwirkende Prüfvorrichtungen. Deshalb wurden Vorrichtungen und Verfahren entwickelt, die berührunglos, beispielsweise mit Elektronen- oder Ionenstrahlen, Funktionsprüfungen erlauben. Entsprechend sind Elektronenstrahlmeßgeräte und Verfahren zur Fehleranalyse von integrierten Schaltungen bekannt.

Bei den bekannten Vorrichtungen wird das zu untersuchende Substrat durch Ablenkung eines Korpuskularstrahles abgetastet. Durch die Ablenkung des Korpuskularstrahls werden jedoch nur wenige Quadratzentimeter des Substrates abgedeckt. Die heutigen Multichip-Modul-Substrate können Abmessungen aufweisen, die 20 x 20 cm überschreiten.

Um auch großflächige Substrate mit Hilfe eines Korpuskularstrahles testen zu können, hat man daher einen verschiebbaren Tisch vorgesehen, auf dem das Substrat gehaltert wird, der dann in eine Ebene senkrecht zum Elektronenstrahl verfahren werden kann. Der abtastbare Bereich von Substraten läßt sich auf diese Weise in ausreichendem Maße vergrößern. Man nimmt jedoch den Nachteil in Kauf, daß das Verschieben des Tisches im Vergleich zum Abtasten des Substrates durch Ablenkung des Korpuskularstrahles wesentlich mehr Zeit benötigt. Man ist daher bestrebt, den abtastbaren und auswertbaren Bereich auf einem Substrat durch Ablenkung des Korpuskularstrahles zu vergrößern.

Durch eine Vergrößerung des Abtastbereiches ergibt sich jedoch die Problematik, daß der Korpuskularstrahl auch bei größeren Ablenkwinkeln auf einen hinreichend kleinen Durchmesser konzentriert werden muß. Um dies zu erreichen, hat man Elemente für die dynamische Fokussierung und Astigmatismuskorrektur vorgesehen.

Beim Abtasten von größeren Bereichen eines Substrates durch Ablenkung des Elektronenstrahls ergibt sich ferner die Schwierigkeit, die an einem bestimmten Ort ausgelösten Sekundärkorpuskel zum Detektor zu führen. Aus der EP-B-0 370 276 wird eine spezielle Detektor- und Kollektor-Ausführung beschrieben, die eine möglichst gleichförmige Detektionscharakteristik über den gesamten Abtastbereich aufweist.

Der Erfindung liegt die Aufgabe zugrunde, ein Verfahren und eine Vorrichtung gemäß den Oberbegriffen der Ansprüche 1, 11 und 13 anzugeben, wodurch das Testen von großflächigen Substraten weiter verbessert wird. Erfindungsgemäß wird diese Aufgabe durch die kennzeichnenden Merkmale der Ansprüche 1, 11 und 13 gelöst.

Mit immer größer werdenden Ablenkwinkeln verändert sich auch das Detektorsignal insofern, als der Ort der am Substrat ausgelösten Sekundärkorpuskel bezüglich der Position des Detektors einen immer größer werdenden Einfluß auf die Anzahl der Sekundärkorpuskel nimmt, die zum Detektor gelangen. Mit anderen Worten variiert das Detektorsignal in starkem Maße mit dem Ort der ausgelösten Sekundärkorpuskel bezüglich der Position des Detektors.

Um nun eine gleichmäßige Signalauswertung über die gesamte Fläche zu erreichen, wird daher der Ort der am Substrat ausgelösten Sekundärkorpuskel bezüglich der Position des Detektors beim Testen berücksichtigt. Dabei gibt es prinzipiell zwei Varianten:
1. Es werden Mittel vorgesehen, die die Sekundärelektronen vom Substrat zum Detektor lenken und derart angesteuert werden, daß sich ein vom Ort unabhängiges Detektorsignal am Detektor einstellt.
2. Der Ort der ausgelösten Sekundärelektronen wird erst bei der Auswertung, d.h. bei einem Vergleich mit dem Sollsignal berücksichtigt, wobei entweder die Detektorsignale mit ortsabhängigen Sollsignalen verglichen werden, oder die Detektorsignale in Abhängigkeit des Ortes korrigiert und dann mit einem Sollsignal verglichen werden.

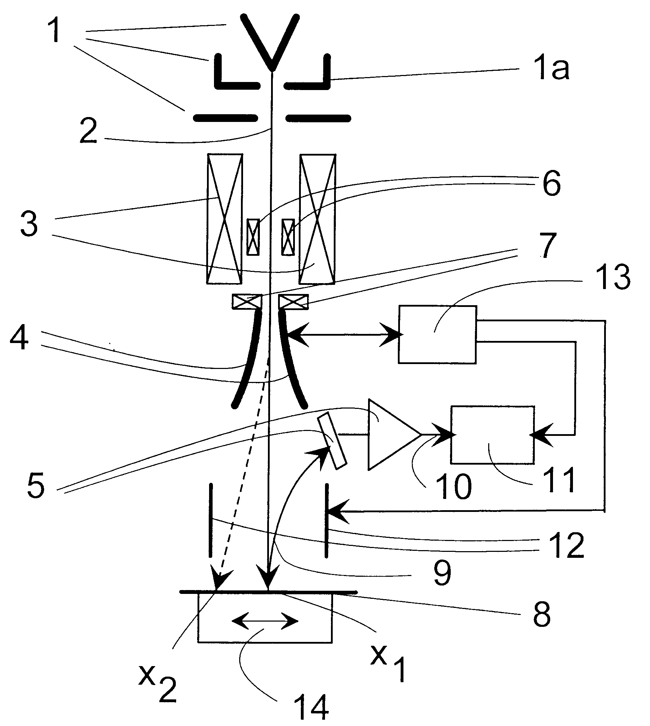

Weitere Ausgestaltungen der Erfindung sind Gegenstand der Unteransprüche und werden anhand der nachfolgenden Beschreibung und der Zeichnung näher erläutert.

Die in der Zeichnung dargestellte Vorrichtung besteht im wesentlichen aus einer Korpuskularstrahlquelle 1, insbesondere einer Elektronenstrahlquelle zur Erzeugung eines Korpuskularstrahles 2, eine Optik 3 zur Fokussierung des Korpuskularstrahles, eine Ablenkeinrichtung 4 sowie einen Detektor 5.

Zur Erzeugung eines gepulsten Korpuskularstrahles weist die Korpuskularstrahlquelle 1 eine Strahlaustasteinrichtung 1a auf. Zur Korrektur des Korpuskularstrahles besonders bei größeren Ablenkungen, sind Mittel 6 zur Korrektur der Fokussierung und Mittel 7 zur Korrektur des Astigmatismus vorgesehen.

Der Korpuskularstrahl 2 wird auf ein zu untersuchendes Substrat 8 gerichtet, wobei Sekundärkorpuskel 9 ausgelöst werden, die zumindest zum Teil vom Detektor 5 detektiert werden. Die detektierten Sekundärkorpuskel 9 werden im Detektor 5 in ein elektrisches Detektorsignal 10 umgewandelt, das einer Einrichtung 11 zur Auswertung des Detektorsignals zugeführt wird, wo das Detektorsignal 10 mit einem Sollsignal verglichen wird.

Zur Verbesserung des Testverfahrens ist gemäß der Erfindung nun vorgesehen, daß der Ort der am Substrat 8 ausgelösten Sekundärkorpuskel 9 bezüglich der Position des Detektors 5 beim Testen berücksichtigt wird. Hierbei sind prinzipiell zwei Varianten denkbar, die sowohl getrennt, aber auch vorteilhaft miteinander kombiniert werden können.

Die erste Variante besteht darin, daß Mittel 12 zur Lenkung der Sekundärkorpuskel vom Substrat 8 zum Detektor 5 vorgesehen sind, die in Abhängigkeit des Ortes der ausgelösten Sekundärkorpuskel bezüglich der Position des Detektors über eine Steuereinrichtung 13 angesteuert werden.

Diesem Verfahren liegt der Gedanke zugrunde, daß sich bei zwei unterschiedlichen Orten x₁ und x₂ am Substrat 8 unterschiedliche Detektorsignale ergeben, wenn die sonstigen Bedingungen, d.h. insbesondere die Anzahl der ausgelösten Sekundärkorpuskel, identisch sind. Dies beruht darauf, daß die ausgelösten Korpuskel in verschiedensten Richtungen am Substrat 8 ausgelöst werden und es daher erforderlich ist, die Sekundärelektronen zum Detektor zu lenken. Hierfür werden Absaugelektronen vorgesehen, die für kleine Abtastbereiche von wenigen Quadratzentimetern zu zufriedenstellenden Ergebnissen führen. Bei großen Ablenkungen können jedoch deutlich unterschiedliche Detektorsignale entstehen, obwohl das auf dem Substrat untersuchte Objekt in völlig identischer Weise funktioniert und lediglich seine Lage auf dem Substrat zu einem verringerten Detektorsignal führt, das möglicherweise den erforderlichen Sollwert nicht mehr erreicht.

Die Mittel 12 zur Lenkung der ausgelösten Sekundärelektronen bestehen beispielsweise aus mehreren plattenförmigen Ablenkelektroden, die je nach dem Ort der ausgelösten Sekundärelektronen mit verschiedenen Spannungen belegt werden.

Durch eine entsprechende Eichung läßt sich daher für jeden Abtastpunkt des Korpuskularstrahles eine zugehörige Spannung an die Mittel 12 zur Lenkung der Sekundärkorpuskel anlegen, so daß über den gesamten Abtastbereich ein gleichmäßiges Detektorsignal erhalten werden kann.

Die in der Zeichnung dargestellte Vorrichtung weist daher eine Steuereinrichtung 13 auf, die mit der Ablenkeinrichtung 4 und den Mitteln 12 zur Lenkung der Sekundärkorpuskel in Verbindung steht. Auf diese Weise ist eine synchronisierte Ansteuerung der Mittel 12 zur Lenkung der Sekundärkorpuskel in Abhängigkeit des Ortes, auf den der Korpuskularstrahl gerichtet ist, gewährleistet.

Die erforderlichen Ansteuersignale für die Mittel 12 zur Lenkung der Sekundärkorpuskel sind beispielsweise für jeden Ort des Substrates abgespeichert und werden vorzugsweise in einem Eichvorgang für verschiedene Punkte des Abtastfeldes empirisch ermittelt. Alternativ können die Ansteuersignale auch unmittelbar vor der Signalerfassung über eine ortsabhängige Funktion berechnet werden.

Die zweite erfindungsgemäße Variante beruht darauf, daß die durch den Ort der ausgelösten Sekundärkorpuskel bedingte Abhängigkeit des Detektorsignales erst bei der Auswertung des Detektorsignales berücksichtigt wird. So wäre es denkbar, daß die jeweils ermittelten Detektorsignale mit jeweiligen ortsabhängigen Sollsignalen verglichen werden. Alternativ hierzu könnte das ortsabhängige Detektorsignal zunächst in ein vom Ort unabhängiges Detektorsignal korrigiert werden, um dann mit einem Sollsignal verglichen zu werden.

Damit der Einrichtung 11 zur Auswertung der Detektorsignale 10 die jeweiligen Informationen über den zugehörigen Ort der ausgelösten Sekundärkorpuskel zur Verfügung stehen, ist diese Einrichtung 11 mit der Steuereinrichtung 13 verbunden, die die Ablenkeinrichtung 4 ansteuert.

In einem bevorzugten Ausführungsbeispiel werden beide oben beschriebenen Varianten, nämlich die ortsabhängige Ansteuerung der Mittel zur Lenkung der Sekundärkorpuskel und die ortsabhängige Auswertung berücksichtigt.

Eine besondere Ausführung der großflächigen Abtastung ergibt sich dann, wenn der Abtastbereich des Korpuskularstrahles gerade so groß gewählt wird, daß eine gesamte Einheit des Substrats durch Strahlablenkung getestet werden kann. Eine solche Einheit stellt beispielsweise eine Displaymatrix dar, die sich zusammen mit weiteren Matrizen auf einer Glasplatte befindet. Auch eine Leiterplatte, die vor der Vereinzelung auf einem Nutzen aus mehreren Leiterplatten gefertigt wurde, stellt eine solche Einheit dar.

Mit zunehmender Größe des zu prüfenden Substrats ist eine Abtastung allein durch Strahlablenkung, selbst mit den oben genannten Korrekturen und Maßnahmen für die Sekundärelektronendetektion, nicht mehr durchführbar. Eine Kombination der Strahlablenkung mit einer mechanischen Verschiebung des Substrates erlaubt dann dennoch einen Test. Das Substrat 8 wird zu diesem Zweck auf einem Tisch 14 gehaltert, der zumindest in einer Ebene senkrecht zum Korpuskularstrahl verschiebbar ist. Die Eigenschaften der Sekundärkorpuskeldetektion lassen sich dadurch optimieren, daß die Ablenkung des Korpuskularstrahles vorzugsweise in eine Richtung erfolgt, während das Substrat mechanisch in der dazu senkrechten Richtung verschoben wird.

Da die Funktionen oder Daten, nach denen die Lenkung der Sekundärelektronen und der Signalvergleich durchgeführt werden, auch vom Prüfling beeinflußt werden können, ist zusätzlich die Speicherung der Daten bzw. Funktionen mit Zugehörigkeit zum jeweiligen Prüfungstyp vorgesehen. Bei Realisierung dieses Merkmals werden jeweils vor Testbeginn die zu einem Prüfling gehörenden Detektionsparameter basierend auf der Identifizierung des Prüflingstyps automatisch eingestellt. Zusätzlich können weitere Betriebsparameter gespeichert werden, z.B. Beschleunigungsspannung, Strahlstrom, Linsenströme, Strahlpulsdauer usw..

Die zur Strahlpositionierung notwendigen Ansteuersignale für die Ablenkeinrichtung 4 und die Korrekturelemente 6, 7 können beispielsweise dadurch erzeugt werden, daß die Prüfpunktkoordinaten unmittelbar vor der Strahlpositionierung in korrigierte Ansteuersignale umgerechnet werden. Dabei werden systemspezifische Korrekturen angebracht, die beispielsweise die Systemverzeichnung berücksichtigen. Die Prüfpunktkoordinaten können unmittelbar vor der Strahlpositionierung aus Prüflingsdaten berechnet werden. So besteht beispielsweise die Datenbasis einer TFT-Matrix, die getestet werden soll, aus den Angaben: Ursprungskoordinaten, Periodizität (Pitch) und Zahl der Zeilen bzw. Spalten. Bei der Prüfung werden dann jeweils unmittelbar vor der Strahlpositionierung die entsprechenden Bildpunktkoordinaten aus diesen Daten berechnet.

Alternativ dazu können die Prüfpunktkoordinaten auch aus einer Datei gelesen werden. Diese Ausführung wird beispielsweise beim Test einer Leiterplatte verwendet, da die zu adressierenden Kontaktpunkte nicht in einer regelmäßigen Abfolge angeordnet sind. Bei regelmäßiger Anordnung der Prüfpunkte kann die Abfolge der adressierten Punkte so berechnet werden, daß der Ablenkwinkel zwischen benachbarten Testpunkten minimal wird. Dieses Betriebsverfahren besteht beispielsweise beim Test einer TFT-Matrix darin, daß die Bildpunkte jeweils spaltenweise oder zeilenweise mäanderförmig, d.h. benachbarte Spalten bzw. Zeilen jeweils in Gegenrichtung, abgetastet werden.

Durch die erfindungsgemäße Berücksichtigung des Ortes der ausgelösten Sekundärkorpuskel bezüglich der Position des Detektors können Substrate bis zu einem Durchmesser von 30 cm und mehr getestet werden.

## Patentansprüche

1. Verfahren zum Testen eines Substrats, wobei ein Korpuskularstrahl (2) auf das Substrat (8) gerichtet wird und ausgelöste Sekundärkorpuskel (9) mit einem Detektor (5) detektiert und anschließend ausgewertet werden,
dadurch gekennzeichnet, daß der Ort (x₁, x₂) der am Substrat ausgelösten Sekundärkorpuskel bezüglich der Position des Detektors beim Testen berücksichtigt wird.

2. Verfahren nach Anspruch 1, dadurch gekennzeichnet, daß Mittel (12) zur Lenkung der Sekundärkorpuskel vom Substrat (8) zum Detektor (5) vorgesehen sind, die in Abhängigkeit des Ortes (x₁, x₂) der ausgelösten Sekundärkorpuskel (9) bezüglich der Position des Detektors (5) angesteuert werden.

3. Verfahren nach Anspruch 2, dadurch gekennzeichnet, daß die Mittel (12) zur Lenkung der Sekundärkorpuskel derart angesteuert werden, daß sich ein vom Ort (x₁, x₂) unabhängiges Detektorsignal (10) am Detektor (5) einstellt.

4. Verfahren nach Anspruch 1, dadurch gekennzeichnet, daS der Korpuskularstrahl (2) zum Abtasten des Substrates abgelenkt wird.

5. Verfahren nach Anspruch 1, dadurch gekennzeichnet, daß der Ort (x₁, x₂) der am Substrat ausgelösten Sekundärkorpuskel bezüglich der Position des Detektors bei der Auswertung berücksichtigt wird.

6. Verfahren nach Anspruch 5, dadurch gekennzeichnet, daß der Detektor (5) ein Detektorsignal (10) erzeugt, das bei der Auswertung mit einem Sollsignal verglichen wird.

7. Verfahren nach Anspruch 1, dadurch gekennzeichnet, daß der Detektor (5) ein Detektorsignal (10) erzeugt, das auf den an einem bestimmten Ort (x₁, x₂) auf dem Substrat ausgelösten Sekundärkorpuskeln (9) beruht und das Detektorsignal (10) mit einem Sollsignal verglichen wird, wobei beim Vergleich der Ort (x₁, x₂) der ausgelösten Sekundärkorpuskel (9) bezüglich der Position des Detektors (5) berücksichtigt wird.

8. Verfahren nach Anspruch 1, dadurch gekennzeichnet, daß der Korpuskularstrahl (2) abgelenkt wird, um das Substrat abzutasten und das Substrat (8) ferner auf einem verfahrbaren Tisch (14) gehaltert ist, wobei die Ablenkung gleichzeitig und synchronisiert mit der Verschiebung des Tisches erfolgt.

9. Verfahren nach Anspruch 3, dadurch gekennzeichnet, daß zunächst eine Eichung durchgeführt wird, bei der die Werte für die Ansteuerung der Mittel (12) zur Lenkung der Sekundärkorpuskel ermittelt und abgespeichert werden.

10. Verfahren nach Anspruch 3, dadurch gekennzeichnet, daß die Werte der Ansteuerung der Mittel (12) zur Lenkung der Sekundärkorpuskel unmittelbar vor dem Detektieren mittels einer ortsabhängigen Funktion berechnet werden.

11. Vorrichtung zum Testen eines Substrats mit
- Mitteln (1) zur Erzeugung eines Korpuskularstrahls (2),
- einem Detektor (5) zum Nachweis von am Substrat durch den Korpuskularstrahl ausgelösten Sekundärkorpuskeln (9) und zur Erzeugung eines Detektorsignals (10),
- Mitteln (12) zur Lenkung der Sekundärkorpuskel (9) zum Detektor (5) und
- einer Einrichtung (11) zur Auswertung des Detektorsignals (10),
dadurch gekennzeichnet, daß
- eine Steuereinrichtung (13) vorgesehen ist, die die Mittel (12) zur Lenkung der Sekundärkorpuskel in Abhängigkeit vom Ort der ausgelösten Sekundärkorpuskel derart ansteuert, daß sich ein vom Ort unabhängiges Detektorsignal ergibt.

12. Vorrichtung nach Anspruch 11, dadurch gekennzeichnet, daß die Mittel (12) zur Lenkung der Sekundärkorpuskel (9) durch Ablenkelektroden gebildet werden.

13. Vorrichtung zum Testen eines Substrats mit
- Mitteln (1) zur Erzeugung eines Korpuskularstrahles (2),
- Mitteln (4) zur Ablenkung des Korpuskularstrahls (2) auf einem bestimmten Ort des Substrats (8),
- einem Detektor (5) zum Nachweis von am Substrat durch den Korpuskularstrahl ausgelösten Sekundärkorpuskeln und
- einer Einrichtung (11) zur Auswertung des Detektorsignals,
dadurch gekennzeichnet, daß
- eine Steuereinrichtung (13) vorgesehen ist, die mit den Mitteln (4) zur Ablenkung des Korpuskularstrahles und den Mitteln (11) zur Auswertung des Detektorsignals in Verbindung steht und die Mittel (11) zur Auswertung des Detektorsignals derart ansteuerbar sind, daß bei der Auswertung des Detektorsignals der Ort der ausgelösten Sekundärkorpuskel bezüglich der Position des Detektors berücksichtigt wird.

14. Vorrichtung nach einem der Ansprüche 11 bis 13, dadurch gekennzeichnet, daß ein verfahrbarer Tisch zur Halterung des Substrats vorgesehen ist.
